# EUROPEAN PATENT SPECIFICATION

(11) **EP 4 086 940 B1**
(45) Date of publication and mention of the grant of the patent: **13.05.2026**
(21) Application number: 22170866.2
(22) Date of filing: 29.04.2022
(51) Int. Cl.: H10P 14/47, H10W 20/00, H10W 20/20, H10W 20/44

(54) **METHOD OF MAKING SUPERCONDUCTING THROUGH SUBSTRATE VIAS**
VERFAHREN ZUR HERSTELLUNG SUPRALEITENDER SUBSTRATDURCHKONTAKTIERUNGEN
PROCÉDÉ DE FABRICATION POUR INTERCONNEXIONS VERTICALES TRAVERSANTES SUPRACONDUCTEURS

(30) Priority: 04.05.2021 FI 20215520
(43) Date of publication of application: 09.11.2022
(60) Divisional application: 26152911.9
(73) Proprietor: IQM Finland Oy, 02150 Espoo (FI)
(72) Inventor: Jenei, Máté, Espoo (FI); Chan, Kok Wai, Espoo (FI); Ahmad, Hasnain, Espoo (FI); Venkatesh, Manjunath Ramachandrappa, Espoo (FI); Liu, Wei, Espoo (FI); Yang, Lily, Espoo (FI); Li, Tianyi, Espoo (FI); Orgiazzi, Jean-Luc, Espoo (FI); Ockeloen-Korppi, Caspar, Espoo (FI); Landra, Alessandro, Espoo (FI); Palma, Mario, Espoo (FI)
(74) Representative: Berggren Oy

(56) References cited:
- WO-A1-2019/117975
- US-A1- 2008 299 759
- US-A1- 2013 140 688
- US-A1- 2018 005 887

## Description

### Technical Field

The invention relates to the fabrication of high component density integrated circuit devices.

### Background

In 3D integrated circuit devices, the integrated circuit components occupy not just a single substrate side, but are distributed on both sides of a substrate and/or on the sides of multiple unified dice, e.g. in a stack. The distribution of circuit components on different layers or design faces provides more flexibility on qubit chip design and also higher component density.

The superconducting through silicon/substrate via (STSV) technology is a core aspect of high-qubit density quantum processing units, in which the two sides of a substrate are electrically connected by a (partially) metallized opening. Mitigating losses in STSVs is necessary to create a versatile 3D-integrated qubit design, in which the STSV can be the part of a qubit, readout structure, or control lines. Furthermore, in existing hollow STSV structures, securing a wafer during resist spinning - an essential step in the formation of quantum processing unit components on the wafer - requires additional fabrication steps because the hollow STSV structures prevent the formation of a sufficiently strong vacuum to hold the wafer on the spinning chuck. These additional fabrication steps may also introduce impurities that can negatively affect the performance of the superconducting connection.

Methods of fabricating TSVs exist in prior art. For example, publications US 2013/140688 A1, US 2008/299759 A1, WO 2019/117975 A1, and US 2018/005887 A1 each present a different method. However, each of these methods comprises fabrication steps, such as chemical mechanical polishing of a metallic layer subsequently used to fabricate electrical components, which may compromise the electrical characteristics of the manufactured product.

### Summary

According to a first aspect of the invention, a method for forming superconducting through substrate vias in a substrate is provided. The method comprises:
- etching one or more openings in the substrate, the etched openings extending from a first side of the substrate partially through the substrate towards a second side of the substrate;
- depositing a seed layer over the first side of the substrate and the interior surfaces of the one or more etched openings in the substrate;
- forming a resist or hardmask on the first side of the substrate above the seed layer, such that the resist or hardmask comprises one or more openings aligned with the etched openings in the substrate, wherein the one or more openings in the resist or hardmask are aligned with the etched openings in the substrate such that the edges of the resist or hardmask are aligned with the edges of the seed layer and only the areas of the seed layer that lie within the openings in the substrate are exposed;
- filling the etched openings in the substrate with a superconducting filler material by electroplating; and
- thinning the substrate by removing material from the second side of the substrate until the deposited seed layer is exposed on the second side of the substrate.

The electroplating may be DC or pulse electroplating.

Filling the etched opening with superconducting filler material is performed by electrodeless electroplating. Lanthanum superconducting filler material may be deposited by this process.

Filling the etched opening with superconducting filler material may be performed using an anode formed of the superconducting filler material.

The superconducting filler material may be rhenium or indium.

Before etching the one or more openings in the substrate the method may comprise forming a second resist or second hardmask, the second resist or second hardmask comprising one or more openings through which the substrate is exposed, wherein the one or more openings in the substrate are etched via the one or more openings in the second resist or second hardmask.

Removing material from the second side of the substrate may be carried out by chemical mechanical polishing, dry blanket etching, physical grinding or chemical etching.

Thinning the substrate may comprise bonding the first side of the substrate to a second substrate, performing chemical mechanical polishing of the second side of the substrate until the deposited seed layer is exposed on the second side of the substrate and debonding the substrate from the second substrate to expose the seed layer and filler material on the first side of the substrate.

Following thinning the substrate, the method may comprise depositing a base metal layer on the first or second side of the substrate.

Following depositing the base metal layer, the method may comprise patterning the base metal layer, wherein patterning the base metal layer comprises depositing a resist on the base metal layer by spin coating.

Patterning the base metal layer may comprise forming components of a quantum processing unit.

### Brief Description of the Drawings

Figures 1A to 1I show the intermediate results of each step of the fabrication process of the present invention.
Figure 2 is a flow chart depicting the fabrication process.

### Detailed Description

The present invention provides a method for manufacturing integrated circuit devices with through-substrate vias (TSVs), e.g. through-silicon vias, to enable an electrical connection of components formed on both sides of the substrate through the vias. The method is particularly suited to the formation of superconducting TSVs that, when cooled below the critical temperature of the superconducting TSV filler material provide superconducting electrical connection of components, such as components of a quantum processing unit, on both sides of the substrate. Such components may be, for example, Josephson junctions or other tunnelling barrier components.

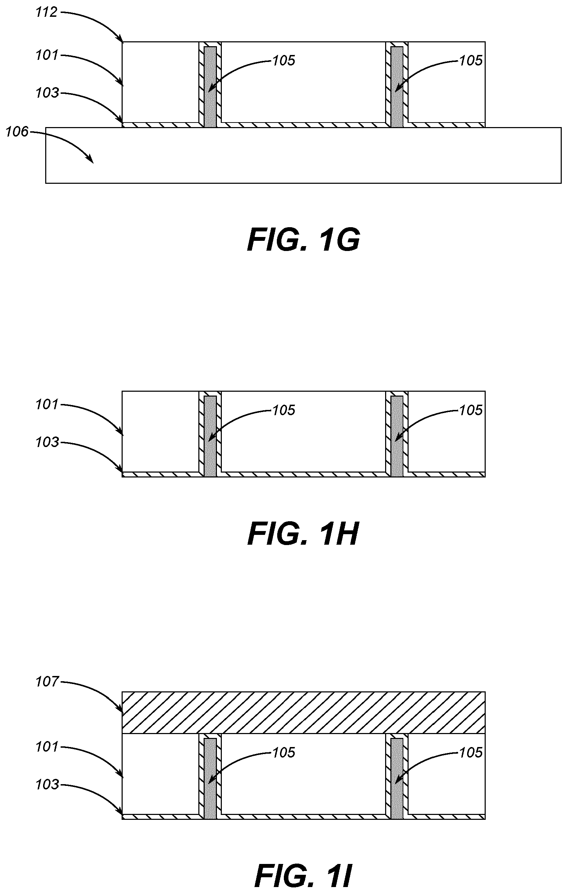

The present invention also provides an integrated circuit product that includes TSVs produced according to the present invention. Such products are characterised by including a substrate which has one or more superconducting TSVs which extend through the substrate from a first side of the substrate to a second side of the substrate. The interior walls of the TSVs coated in a seed layer and the TSVs are filled with a superconducting filler material. An example of the TSVs that can be found in the product of the invention is shown in Figure 1H.

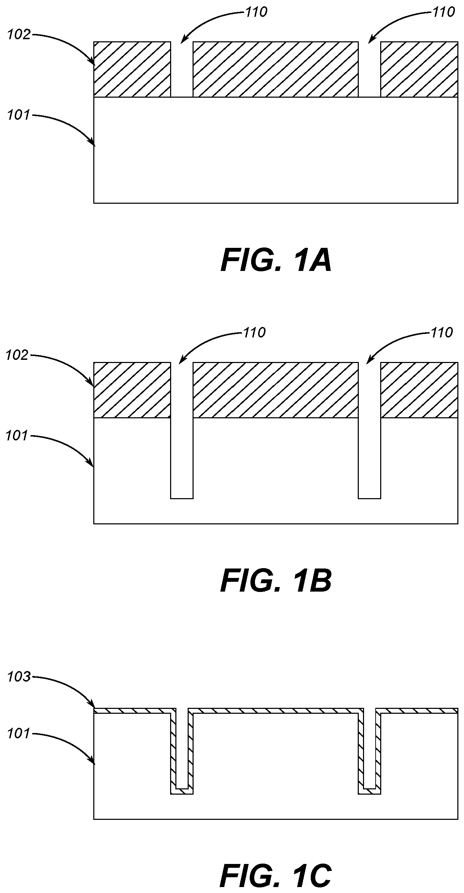

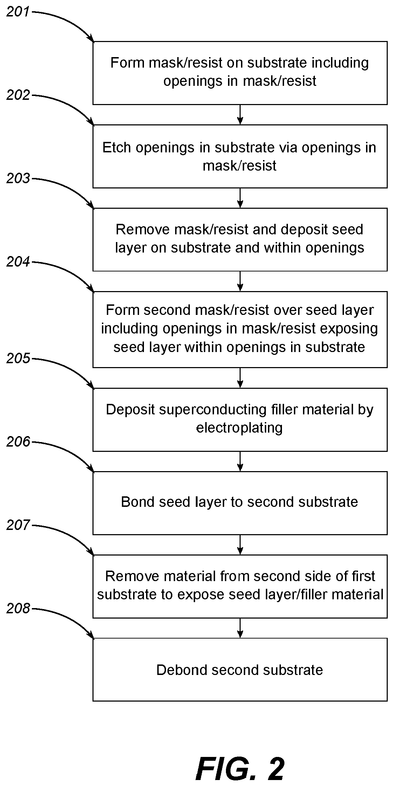

The method of the present invention takes place before the formation of other elements on the substrate, such as quantum circuit components like a base metal layer and Josephson junctions. The method is shown in more detail in Figures 1A to 1I and Figure 2. Figures 1A to 1I show the intermediate results of each step of the fabrication process of the present invention, while Figure 2 is a flow chart depicting the fabrication process.

Figure 1A shows a blank wafer or substrate 101 on which a first mask or resist 102 is formed on one side. The mask/resist 102 include one or more openings 110, which define the locations in which the TSVs will be formed in subsequent steps. Figure 1A shows the result of step 201 of the method shown in Figure 2, in which the mask/resist 102 is formed on a first side of the substrate. The substrate 101 may be a silicon substrate or any other suitable substrate material, such as sapphire, III-V and IV semiconductors, or any other material that is highly resistive, can be deep etched, and tolerates a low pH electroplating plating bath, which is employed in later steps. Mask/resist 102 may be a hardmask or photoresist, for example, and openings 110 may be formed by lithography or any other suitable process which enables openings 110 to be formed in a controlled manner at specific locations above the substrate 101.

Figure 1B shows the substrate 101 and mask/resist 102 following deep etching of the substrate via the openings 110 at step 202 of the process shown in Figure 2. The openings etched into the substate 101 extend partially through the substrate in a direction generally perpendicular to the surfaces of the substrate 101, which are typically parallel. However, it will be appreciated and be clear that the precise direction in which the openings extend through the substrate 101 is not important as long as they extend from the first side of the substrate 101 towards the second side 102, nor is it essential the first and second sides of the substate 101 be parallel. The depth of the openings in the substrate 101 defines the maximum depth of the resulting TSVs, therefore the opening should be etched to a depth at least equal to the minimum width of the final substrate width.

Figure 1C shows the substate 101 and a seed layer 103 that is deposited onto the substrate 101, including within the openings etched into the substrate 101, i.e. covering the interior wall or walls of the opening and the surface at the bottom of the opening, after the mask/resist 102 is removed. Figure 1C therefore shows the result of step 203 of the process shown in Figure 2. The seed layer 103 can be a single layer or a stack of multiple layers and is deposited by sputtering, e-beam evaporation, or atomic-layer deposition (ALD). The seed layer 103 is electrically conductive and forms a superconductor with the superconducting filler material. The seed layer 103 also acts as an adhesion layer, allowing a stronger bond between the substrate 101 and superconducting filler material. In an embodiment, the seed layer 103 is formed of plasma enhanced - ALD deposited titanium nitride, but other materials fulfilling the criteria set out above may be used instead, such as niobium titanium nitride. Alternatively, where physical vapour deposition is used, other materials, such as copper or gold, may be used for the seed layer on the same condition that the metal stack, i.e. the seed layer and filler material, is superconducting, for example as a result of the Holm-Meissner effect.

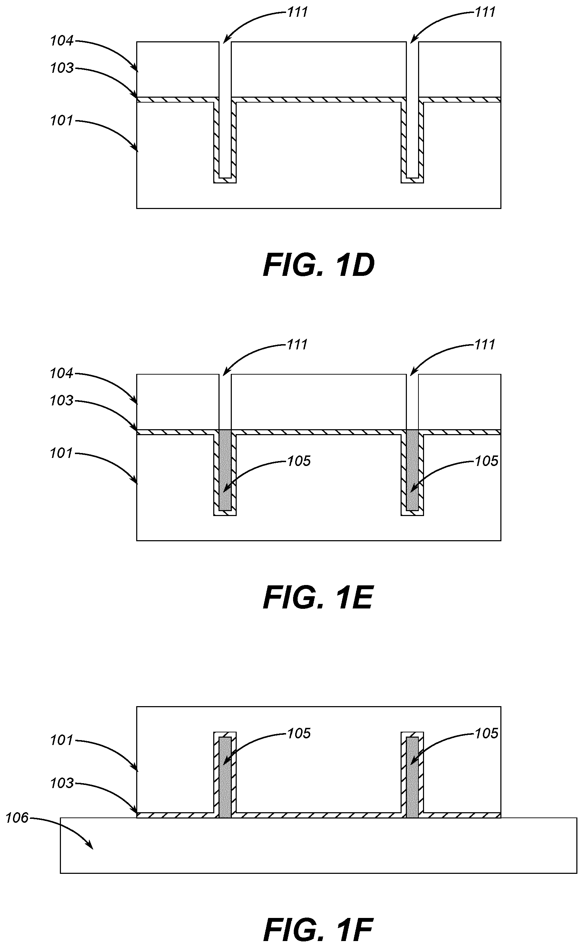

Figure 1D shows the result of the following step 204 shown in Figure 2, in which a second mask/resist 104 is deposited on the seed layer 103 above the substrate 101, i.e. such that the seed layer 103 is positioned between the mask/resist 104 and the substrate 101. Openings 111 are formed in the mask/resist 104 above the existing openings in the substrate 101 and seed layer 103 that were defined by the deep etching of the substrate 101 and subsequently coated with the seed layer 103. The second mask/resist 104 may be a hardmask or photoresist, for example, and openings 111 may be formed by lithography or any other suitable process which enables openings 111 to be formed in a controlled manner at specific locations above the substrate 101. The openings 111 in the mask/resist 104 covering the areas of the seed layer 103 that lie above the surface of the substrate 101, i.e. the edges of the mask/resist 104 align with the edges of the seed layer, such that only the areas of the seed layer 103 that lie within the openings in the substrate 101 exposed.

Figure 1E shows the result after the superconducting filler material 105 is deposited within the openings in the substrate by electroplating at step 205 of method shown in Figure 2. The electroplating process is performed using the seed layer 103 as a cathode of an electrolytic cell, which also includes an anode, which may be made of an inert conductive material ("electrodeless electroplating") or may be made from the superconducting filler material itself, and an electrolyte bath, which contains ions of the superconducting filler material that is to be deposited. The electroplating process can be driven by either direct current or by an alternating current, i.e. using pulse electroplating. For some geometries, e.g. with particularly narrow or deep openings in the substrate, pulse electroplating may be necessary in order to consistently fill the opening. Since the seed layer 103 is covered by the second mask/resist 104 in all areas except those within the openings in the substrate 101, the superconducting filler material 105 is deposited only within the openings.

In existing superconducting TSV processes, the TSVs are typically hollow at the end of the fabrication process as the extremely temperatures under which superconducting devices must operate cause contraction of the materials that the device is formed of at different rates. Thus, elements such as filler material within the TSVs are subject to stresses and additional pressure that may adversely affect performance of the device.

The superconducting filler material 105 is preferably rhenium. Rhenium has the advantageous property that its critical temperature increases under thermal contraction of the device. Furthermore, rhenium has a high melting point (3459K), thus Rhenium does not melt and reflow under the conditions required for the fabrication of components on the substrate 101 after the TSVs have been formed. Where rhenium is used, it may be electroplated in a solution of 18.2MΩ cm water, 25mM ammonium perrhenate (VII) (99%), and 0.1M sulfuric acid (96%-98%). Water-in-salt electrolytes may also contain 5M lithium chloride (98%) and tetrabutylammonium hydrogen sulphate (98%). It will of course be appreciated that the specific rhenium bath chemistry may vary from this example.

Alternatively, other superconducting filler materials may be used, such as indium or lanthanum. Further options for the superconducting filler material include aluminium, tin, lead, niobium or tantalum. Whether the superconducting filler material 105 is rhenium or any other superconducting material, the superconducting filler material 105 fills the opening in the substrate 101 such that the filler material 105 completely blocks the opening in the substrate 101. Therefore, other materials still retain at least the advantage that the TSVs are filled and resist spinning when forming further components after formation of the TSVs can be performed without additional fabrication steps and without contaminating the TSVs with additional materials that might cause interference or dielectric loss.

Figure 1F shows the result of step 206 of the method of Figure 2, in which the mask/resist 104 is removed and the seed layer 103 is bonded to a second substrate 106 to enable the removal of material from the second, exposed side of the substrate 101 using wafer thinning techniques e.g. by chemical mechanical polishing (CMP), as shown in Figure 1G and in step 207 of the method of Figure 2. Material is removed from the second side of the substrate 101 until the seed layer 103 that was deposited at the bottom of the openings in the substrate 101 is exposed. This is sufficient to provide a superconducting connection from one side of the substrate 101 to the other, but material may continue to be removed until the superconducting filler material 105 is exposed. After the seed layer 103 or superconducting filler material 105 is exposed, the second substrate 106 is debonded at step 208 of the method shown in Figure 2 to leave the first substrate 101 with now fully formed TSVs, as shown in Figure 1H. It will be appreciated that other techniques than CMP can be used to expose the seed layer 103 or superconducting filler material 105 on the second side of the substrate 101, in which case the process steps shown in Figures 1F and 1G and steps 206, 207 and 208 may differ. Alternative techniques for exposing the seed layer 103 or superconducting filler material 105 include physical grinding, dry blanket etching or spin etching, for example.

In the completed TSV, the interior walls of each TSV, i.e. the interior walls of the opening in the substrate, are coated by the seed layer 103 and the TSV is filled with the superconducting filler material 105, i.e. the volume enclosed by the seed layer 103 coating the interior walls of the TSV are filled with the superconducting filler material 105.

Figure 1I shows a further step in which a base metal layer 107 is deposited onto the substrate 101 with now formed TSVs. This is a possible first step in the fabrication of components on both sides of the substrate 101, which will ultimately be connected to one another through the TSVs. As such, Figure 1I does not represent a step of the method of forming the TSVs per se.

## Claims

1. A method for forming superconducting through substrate vias in a substrate (101), the method comprising:
etching (202) one or more openings in the substrate (101), the etched openings extending from a first side of the substrate (101) partially through the substrate (101) towards a second side of the substrate (101);
depositing (203) a seed layer (103) over the first side of the substrate (103) and the interior surfaces of the one or more etched openings in the substrate (101);
forming (204) a resist or hardmask (104) on the first side of the substrate (101) above the seed layer (103), such that the resist or hardmask (104) comprises one or more openings (111) aligned with the etched openings in the substrate (101),
wherein the one or more openings (111) in the resist or hardmask (104) are aligned with the etched openings in the substrate (101) such that the edges of the resist or hardmask (104) are aligned with the edges of the seed layer (103) and only the areas of the seed layer (103) that lie within the openings in the substrate (101) are exposed;
filling (205) the etched openings in the substrate (101) with a superconducting filler material (105) by electroplating; and
thinning the substrate (101) by removing (207) material from the second side of the substrate (101) until the deposited seed layer (103) is exposed on the second side of the substrate (101).

2. The method of claim 1, wherein the electroplating is DC or pulse electroplating.

3. The method of any preceding claim, wherein filling (205) the etched opening with superconducting filler material (105) is performed by electrodeless electroplating in which and anode made of an inert conductive material is used.

4. The method of any preceding claim, wherein filling (205) the etched opening with superconducting filler material (105) is performed using an anode formed of the superconducting filler material (105).

5. The method of any preceding claim, wherein the superconducting filler material (105) is rhenium or indium.

6. The method of any preceding claim, wherein before etching (202) the one or more openings in the substrate (101) the method comprises forming (201) a second resist or second hardmask (102), the second resist or second hardmask (102) comprising one or more openings (110) through which the substrate (101) is exposed, wherein the one or more openings in the substrate (101) are etched via the one or more openings (110) in the second resist or second hardmask (102).

7. The method of any preceding claim, wherein removing (207) material from the second side of the substrate (101) is carried out by chemical mechanical polishing, dry blanket etching, physical grinding or chemical etching.

8. The method of claim 7, wherein thinning the substrate comprises bonding (206) the first side of the substrate (101) to a second substrate (106), performing chemical mechanical polishing of the second side of the substrate (101) until the deposited seed layer (103) is exposed on the second side of the substrate (101) and debonding (208) the substrate (101) from the second substrate (106) to expose the seed layer (103) and filler material (105) on the first side of the substrate (101).

9. The method of any preceding claim, wherein following thinning the substrate, the method comprises depositing a base metal layer (107) on the first or second side of the substrate (101).

10. The method of claim 9, wherein following depositing the base metal layer (107), the method comprises patterning the base metal layer (107), wherein patterning the base metal layer (107) comprises depositing a resist on the base metal layer (107) by spin coating.

11. The method of claim 9 or 10, wherein patterning the base metal layer (107) comprises forming components of a quantum processing unit.

## Patentansprüche

1. Verfahren zum Bilden supraleitender Substratdurchkontaktierungen in einem Substrat (101), wobei das Verfahren umfasst:
Ätzen (202) einer oder mehrerer Öffnungen im Substrat (101), wobei sich die geätzten Öffnungen von einer ersten Seite des Substrats (101) teilweise durch das Substrat (101) hindurch in Richtung auf eine zweite Seite des Substrats (101) erstrecken;
Abscheiden (203) einer Keimschicht (103) auf der ersten Seite des Substrats (103) und auf den Innenflächen der einen oder mehrerer geätzter Öffnungen im Substrat (101);
Bilden (204) eines Resists oder einer Hartmaske (104) auf der ersten Seite des Substrats (101) oberhalb der Keimschicht (103), derart, dass der Resist oder die Hartmaske (104) eine oder mehrere Öffnungen (111) umfasst, die mit den geätzten Öffnungen im Substrat (101) ausgerichtet sind, wobei die eine oder mehrere Öffnungen (111) in dem Resist oder der Hartmaske (104) mit den geätzten Öffnungen im Substrat (101) derart ausgerichtet sind, dass die Kanten des Resists oder der Hartmaske (104) mit den Kanten der Keimschicht (103) ausgerichtet sind und nur die Bereiche der Keimschicht (103), die innerhalb der Öffnungen im Substrat (101) liegen, freigelegt sind;
Füllen (205) der geätzten Öffnungen im Substrat (101) mit einem supraleitenden Füllmaterial (105) durch galvanische Abscheidung; und
Dünnen des Substrats (101) durch Entfernen (207) von Material von der zweiten Seite des Substrats (101), bis die abgeschiedene Keimschicht (103) auf der zweiten Seite des Substrats (101) freigelegt ist.

2. Verfahren nach Anspruch 1, wobei die galvanische Abscheidung eine galvanische Abscheidung mit Gleichstrom oder Pulsgalvanisieren ist.

3. Verfahren nach einem vorstehenden Anspruch, wobei das Füllen (205) der geätzten Öffnung mit supraleitendem Füllmaterial (105) mittels elektrodenlosem Galvanisieren durchgeführt wird, bei dem eine Anode aus einem inerten leitfähigen Material verwendet wird.

4. Verfahren nach einem vorstehenden Anspruch, wobei das Füllen (205) der geätzten Öffnung mit supraleitendem Füllmaterial (105) unter Verwendung einer aus dem supraleitenden Füllmaterial (105) gebildeten Anode durchgeführt wird.

5. Verfahren nach einem vorstehenden Anspruch, wobei das supraleitende Füllmaterial (105) Rhenium oder Indium ist.

6. Verfahren nach einem vorstehenden Anspruch, wobei das Verfahren vor dem Ätzen (202) der einen oder mehrerer Öffnungen im Substrat (101) das Bilden (201) eines zweiten Resists oder einer zweiten Hartmaske (102) umfasst, wobei der zweite Resist oder die zweite Hartmaske (102) eine oder mehrere Öffnungen (110) umfasst, durch die das Substrat (101) freigelegt ist, wobei die eine oder mehrere Öffnungen im Substrat (101) über die eine oder mehrere Öffnungen (110) in dem zweiten Resist oder der zweiten Hartmaske (102) geätzt werden.

7. Verfahren nach einem vorstehenden Anspruch, wobei das Entfernen (207) von Material von der zweiten Seite des Substrats (101) durch chemisch-mechanisches Polieren, trockenes Flächenätzen, mechanisches Schleifen oder chemisches Ätzen durchgeführt wird.

8. Verfahren nach Anspruch 7, wobei das Dünnen des Substrats das Bonden (206) der ersten Seite des Substrats (101) an ein zweites Substrat (106) umfasst, das Durchführen eines chemisch-mechanischen Polierens der zweiten Seite des Substrats (101), bis die abgeschiedene Keimschicht (103) auf der zweiten Seite des Substrats (101) freigelegt ist und
Entbonden (208) des Substrats (101) von dem zweiten Substrat (106), um die Keimschicht (103) und das Füllmaterial (105) auf der ersten Seite des Substrats (101) freizulegen.

9. Verfahren nach einem vorstehenden Anspruch, wobei das Verfahren nach dem Dünnen des Substrats das Abscheiden einer Grundmetallschicht (107) auf der ersten oder zweiten Seite des Substrats (101) umfasst.

10. Verfahren nach Anspruch 9, wobei das Verfahren nach dem Abscheiden der Grundmetallschicht (107) das Strukturieren der Grundmetallschicht (107) umfasst, wobei das Strukturieren der Grundmetallschicht (107) das Aufbringen eines Resists auf die Grundmetallschicht (107) durch Rotationsbeschichtung (Spin-Coating) umfasst.

11. Verfahren nach Anspruch 9 oder 10, wobei das Strukturieren der Grundmetallschicht (107) das Bilden von Komponenten einer Quantenverarbeitungseinheit umfasst.

## Revendications

1. Procédé destiné à former des interconnexions verticales traversantes supraconductrices dans un substrat (101), le procédé comprenant :
graver (202) une ou plusieurs ouvertures dans le substrat (101), les ouvertures gravées s'étendant depuis une première face du substrat (101) partiellement à travers le substrat (101) vers une seconde face du substrat (101) ;
déposer (203) une couche de germe (103) sur la première face du substrat (103) et sur les surfaces intérieures de la ou des plusieurs ouvertures gravées dans le substrat (101) ;
former (204) une résine photosensible ou un masque dur (104) sur la première face du substrat (101) au-dessus de la couche de germe (103), de sorte que la résine photosensible ou le masque dur (104) comprenne une ou plusieurs ouvertures (111) alignées avec les ouvertures gravées dans le substrat (101), dans lequel la ou les plusieurs ouvertures (111) dans la résine photosensible ou le masque dur (104) sont alignées avec les ouvertures gravées dans le substrat (101) de sorte que les bords de la résine photosensible ou du masque dur (104) soient alignés avec les bords de la couche de germe (103) et seules les zones de la couche de germe (103) qui se situent à l'intérieur des ouvertures dans le substrat (101) soient exposées ;
remplir (205) les ouvertures gravées dans le substrat (101) avec un matériau de remplissage supraconducteur (105) par électrodéposition ; et
amincir le substrat (101) en enlevant (207) du matériau de la seconde face du substrat (101) jusqu'à ce que la couche de germe (103) déposée soit exposée sur la seconde face du substrat (101).

2. Procédé selon la revendication 1, dans lequel l'électrodéposition est une électrodéposition en courant continu ou une électrodéposition pulsée.

3. Procédé selon l'une quelconque des revendications précédentes, dans lequel le remplissage (205) de l'ouverture gravée avec le matériau de remplissage supraconducteur (105) est réalisé par électrodéposition sans électrode dans laquelle une anode constituée d'un matériau conducteur inerte est utilisée.

4. Procédé selon l'une quelconque des revendications précédentes, dans lequel le remplissage (205) de l'ouverture gravée avec le matériau de remplissage supraconducteur (105) est réalisé en utilisant une anode formée du matériau de remplissage supraconducteur (105).

5. Procédé selon l'une quelconque des revendications précédentes, dans lequel le matériau de remplissage supraconducteur (105) est du rhénium ou de l'indium.

6. Procédé selon l'une quelconque des revendications précédentes, dans lequel, avant de graver (202) la ou les plusieurs ouvertures dans le substrat (101), le procédé comprend le fait de former (201) une seconde résine photosensible ou un second masque dur (102), la seconde résine photosensible ou le second masque dur (102) comprenant une ou plusieurs ouvertures (110) à travers lesquelles le substrat (101) est exposé, dans lequel la ou les plusieurs ouvertures dans le substrat (101) sont gravées par le biais de la ou des plusieurs ouvertures (110) dans la seconde résine photosensible ou le second masque dur (102).

7. Procédé selon l'une quelconque des revendications précédentes, dans lequel l'enlèvement (207) de matériau de la seconde face du substrat (101) est mis en œuvre par polissage chimico-mécanique, gravure sèche, meulage mécanique ou gravure chimique.

8. Procédé selon la revendication 7, dans lequel l'amincissement du substrat comprend le fait de coller (206) la première face du substrat (101) à un second substrat (106), le fait de réaliser un polissage chimico-mécanique de la seconde face du substrat (101) jusqu'à ce que la couche de germe (103) déposée soit exposée sur la seconde face du substrat (101) et
le fait de décoller (208) le substrat (101) du second substrat (106) afin d'exposer la couche de germe (103) et le matériau de remplissage (105) sur la première face du substrat (101).

9. Procédé selon l'une quelconque des revendications précédentes, dans lequel, à la suite de l'amincissement du substrat, le procédé comprend le fait de déposer une couche métallique de base (107) sur la première ou la seconde face du substrat (101).

10. Procédé selon la revendication 9, dans lequel, à la suite du dépôt de la couche métallique de base (107), le procédé comprend le fait de façonner la couche métallique de base (107), dans lequel le façonnage de la couche métallique de base (107) comprend le fait de déposer une résine photosensible sur la couche métallique de base (107) par revêtement par centrifugation.

11. Procédé selon la revendication 9 ou la revendication 10, dans lequel le façonnage de la couche métallique de base (107) comprend le fait de former des composants d'une unité de traitement quantique.
